# EUROPÄISCHE PATENTANMELDUNG

(11) **EP 1 339 122 A2**
(43) Veröffentlichungstag der Anmeldung: **27.08.2003**
(21) Anmeldenummer: 03001406.2
(22) Anmeldetag: 22.01.2003
(51) Int. Cl.: H01M 6/18, H01M 10/40

(54) **Verfahren zur Herstellung von galvanischen Elementen**

(30) Priorität: 20.02.2002 DE 10207070
(71) Anmelder: VARTA Microbattery GmbH, 30419 Hannover (DE)
(72) Erfinder: Hald, Rainer, 73479 Ellwangen (DE); Gaugler, Winfried, 73479 Ellwangen-Eigenzell (DE); Holl, Konrad, Dr., 73434 Aalen-Dewangen (DE); Haug, Peter, Dr., 73479 Ellwangen (DE); Wöhrle, Thomas, Dr., 73479 Ellwangen (DE); Birke, Peter, Dr., 73479 Ellwangen (DE); Ilic, Dejan, Dr., 73479 Ellwangen (DE)
(74) Vertreter: Patentanwälte Ruff, Wilhelm, Beier, Dauster & Partner

(57) **Zusammenfassung**

Bei einem Verfahren zur Herstellung von galvanischen Elementen, die aus einer Vielzahl aufeinander gestapelter Einzelzellen bestehen, wird die Funktionsfähigkeit der Einzelzellen vor dem Einbringen eines organischen Elektrolyten und vor der Bildung eines Zellenstapels durch Messung der Impedanz der Einzelzelle mittels Wechselspannung überprüft. Die Einzelzellen bestehen jeweils aus auf einen Separator (1) laminierten Elektrodenfolien. Dabei ist mindestens eine der Elektroden (2) eine Lithium-interkalierende Elektrode, in deren Polymermatrix im Polymer unlösliche elektrochemisch aktive Materialien fein dispergiert sind. Die Impedanzmessung erfolgt als Vierpolmessung bei einer Frequenz von ca. 1 kHz mittels der Federkontakte (4), die Ableiter (3) des Laminats kontaktieren.

## Beschreibung

Gegenstand der Erfindung ist ein Verfahren nach dem Oberbegriff des Anspruchs 1, insbesondere zur Herstellung von galvanischen Elementen, die im fertigen Zustand aus einer Vielzahl aufeinander gestapelter Einzelzellen mit einem Elektrolyten bestehen, wobei die Einzelzellen jeweils aus Elektrodenfolien bestehen, die auf einen Separater laminiert sind. Mindestens eine der Elektroden ist eine Lithium-interkalierende Elektrode, in deren Polymermatrix elektrochemisch aktive Materialien fein dispergiert sind, die im Polymer unlöslich sind.

Wiederaufladbare Lithiumzellen enthalten im allgemeinen entweder einen Elektrodenwickel oder einen Zellenstapel, der aus mehreren Einzelelementen besteht. Während man bei einem Wickel einen losen Verbund von Elektroden und Separator aufwickelt, wobei nur Elektrode und die zugehörige Ableiterelektrode mechanisch fest verbunden sind, werden Zellenstapel aus einer Vielzahl von Einzelzellen aufgebaut. Die Einzelzellen oder Einzelelemente, aus denen ein solcher Zellenstapel zusammengesetzt ist, sind ein Laminat, das aus Ableitern, aktivem Elektrodenfilm und Separator erzeugt wird. Derartige Laminate aus fest verbundenen Einzelteilen werden insbesondere als sogenannte Bizellen mit den möglichen Sequenzen negative Elektrode / Separator / positive Elektrode / Separator / negative Elektrode oder positive Elektrode / Separator / negative Elektrode / Separator / positive Elektrode hergestellt, da ein solcher symmetrischer Aufbau ein Verspannen und Durchbiegen der Zelle aufgrund abweichender physikalischer Eigenschaften von negativer und positiver Elektrode bei der Lamination weitgehend verhindert.

Ein Elektrodenwickel dagegen gestattet eine vorherige Lamination nicht, da der Gesamtverbund dann einen Dickenbereich aufweisen würde, der beim Wickeln aufgrund der engen auftretenden Biegeradien zu Rissen im Material führen würde. Würde man die Elektroden beim Elektrodenwickel so dünn ausgestalten, dass derartige Risse nicht auftreten, wird das Verhältnis zwischen Totmaterial und Aktivmaterial in der Zelle zu ungünstig.

Dem Dokument US-PS 5,460,904 ist ein Verfahren zur Herstellung von wiederaufladbaren Lithium-lonenbatterien zu entnehmen. Bei diesem Verfahren werden aktive Materialien und Zusätze, wie gegebenenfalls Leitfähigkeitsverbesserer in den Elektroden oder Stabilisatoren im Separator, ein spezielles Copolymer, Polyvinylidendifluorid-Hexafluorpropylen (PVDF-HFP) sowie Anteile eines Weichmachers, typischerweise Dibuthylphthalat (DBP), nach Hinzugabe von Aceton zum Lösen des Copolymers intensiv gemischt und zu einer Folie ausgezogen. Die so gebildeten Elektrodenfolien und Separatorfolien werden in mehreren Laminationsprozessen zu den oben beschriebenen Bizellen verarbeitet. Mehrere Bizellen werden dann zu einem Stapel aufgeschichtet, der nach Einlegen in einen Behälter aus beispielsweise tiefgezogener Aluminiumverbundfolie, Befüllen mit Elektrolyt, Versiegeln mit einem Deckel, Formation und Endverschluss zu einer fertigen Batterie verarbeitet wird.

Der Aufbau von galvanischen Elementen aus solchen Laminaten weist erhebliche Vorteile auf. Während in einer Wickelzelle der Kontakt zwischen Separator und Elektroden schon bei geringer Gasung gestört wird, kann dies bei einem Laminat nicht auftreten. Darüber hinaus sind solche Bizellen hervorragend für eine Hochgeschwindigkeitsproduktion geeignet. Die große Vielfalt von Form und Bauhöhe ist den Möglichkeiten von Wickelelektroden deutlich überlegen. Extrem dünne und flächige Ausgestaltungen sind mittels Wickelelektroden kaum realisierbar.

In der Fertigung sind im allgemeinen Qualitätsprüfschritte erforderlich. Beispielsweise werden galvanische Elemente in der Fertigung durch Messung von Spannung, Kapazität und Widerstand geprüft. Diese Prüfungen erfolgen allerdings stets nach der Fertigung, wenn bereits ein vollständig konfektioniertes galvanisches Element mit Elektrolyt vorliegt.

Der Erfindung liegt die Aufgabe zugrunde, ein Verfahren zu schaffen, welches eine Qualitätsprüfung bei der Herstellung von laminierten Zellenstapeln schon in einem möglichst frühen Zeitpunkt ermöglicht und damit einen frühzeitigen Ausschluss von defekten Zellen aus dem Herstellungsablauf ermöglicht.

Diese Aufgabe wird bei dem eingangs genannten Verfahren durch die Merkmale des Anspruchs 1 gelöst. Weitere sowie bevorzugte Ausgestaltungen des Verfahrens sind den Unteransprüchen zu entnehmen. Der Wortlaut der Ansprüche wird durch ausdrückliche Bezugnahme zum Inhalt der Beschreibung gemacht.

Erfindungsgemäß kann die Funktionsfähigkeit der einzelnen laminierten Bizellen schon vor dem Herstellen eines Zellenstapels und insbesondere vor dem Einbringen eines Elektrolyten mittels einer Impedanzmessung bei Wechselspannung oder Wechselstrom gelöst werden. Bei Zellen, die aus einer Vielzahl von Einzelelementen bestehen, macht eine einzelne, durch Feinschluss oder schlechte Lamination defekte Bizelle später das komplette, typischerweise aus 5 bis 8 parallel verschalteten Bizellen bestehende galvanische Element unbrauchbar. Eine Prüfung auf Kurz- oder Feinschluss mittels einer Gleichstromwiderstandsmessung ist nur schwer durchführbar, da Polarisations- und Diffusionseffekte die Messung stark beeinflussen. Bei Anlegen eines Gleichstromes kann es über Restwasserzersetzung zu induzierter Protonenleitfähigkeit und damit einem der Formierung ähnlichen Prozess kommen. Sobald das Laminat vorliegt, existiert zwar ein reproduzierbar zu fertigender Verbund. Dieser ist aber zu diesem Zeitpunkt noch nicht mit Elektrolyt aktiviert. Er besitzt also, da zwischen den Elektroden ein Separator angeordnet ist, in diesem Zustand theoretisch einen unendlich hohen Widerstand. Wenn die Laminationsqualität nicht geprüft wird und eine Prüfung erst beim Zellenstapel erfolgt, wird der gesamte Stapel, der aus 5 bis 8 solcher Laminate besteht, verworfen, obwohl nur ein einzelnes Laminat defekt ist.

Erfindungsgemäß hat sich überraschenderweise herausgestellt, dass bei einer Impedanzmessung an solchen Bizellenlaminaten endliche und engere reproduzierbare Impedanzwerte erhalten werden, die als effektives Qualitätskriterium eingesetzt werden können. Verantwortlich für diesen endlichen Impedanzwert sind im Laminat zu diesem Zeitpunkt enthaltene Stoffe wie Plastifizierung und/oder Restwasser, die üblicherweise erst in den folgenden Arbeitsschritten der Zellenherstellung entfernt werden. Diese späteren Aufarbeitungsschritte bestehen in einem nasschemischen Auswaschen und/oder einer thermisch aktivierten Verdampfung des Weichmachers und einem Vakuumtrockenschritt bei erhöhter Temperatur, beispielsweise bei 80°C zur Minimierung des Restwassergehaltes.

Zur Bestimmung der Impedanz der Bizellen kann eine Vierpolmessung durchgeführt werden bei einer Frequenz von einigen Hz bis in den hohen kHz-Bereich hinein. Vorteilhaft sind es ca. 100 Hz bis 100 kHz, beispielsweise 1 kHz. Bei der Auswertung der Messung können vorteilhaft noch der Betrag und/oder der Phasenwinkel der Impedanz berücksichtigt werden.

Die Impedanzbestimmung kann über Federkontakte erfolgen, die Ableiter des Laminats oder der Elemente kontaktieren.

Es ist möglich, die ermittelten Impedanzwerte kumulativ zu sammeln. Aus den Messwerten kann eine Verteilungskurve gebildet werden. Einzelzellen, deren Impedanz außerhalb von vorher bestimmten Grenzwerten der Verteilungskurve liegen, werden dann aussortiert. Solche auszusortierenden Zellen können als Ausschusszellen markiert werden. Dies kann beispielsweise durch Abschneiden eines Ableiters des Laminats erfolgen.

Diese und weitere Merkmale von bevorzugten Weiterbildungen der Erfindung gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird.

Ein Ausführungsbeispiel der Erfindung ist in den Zeichnungen schematisch dargestellt und wird im folgenden näher erläutert. In den Zeichnungen zeigen:
- Figur 1: einen Ausschnitt aus dem aus der Fertigungseinrichtung laufenden Elektrodenband und
- Figur 2: eine Gaußverteilung des Betrags der Impedanzmesswerte.

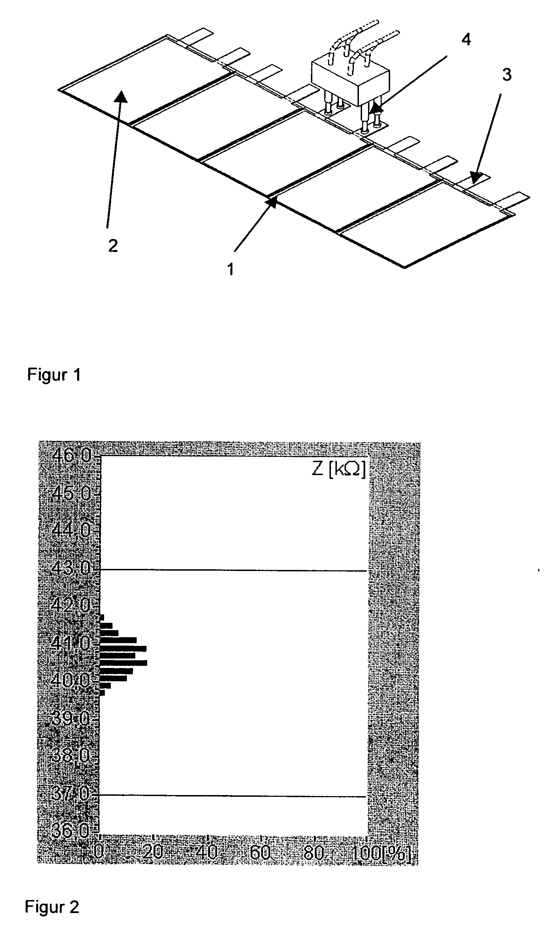

Figur 1 zeigt einen Ausschnitt aus dem aus der Fertigungseinrichtung laufenden Elektrodenband, bei dem auf einem Separator 1 die Elektroden 2 auflaminiert sind. Die Elektroden 2 bestehen aus jeweils aktivem Material, welches auf eine Ableiterelektrode aufgebracht ist, wobei die Ableiterelektroden jeweils mit Fahnenableitern 3 versehen sind. Auf diese Fahnenableiter 3 werden zur Vierpolimpedanzmessung je 2 mit Federn gelagerte Kontakte 4, die vorzugsweise vergoldet sind, aufgesetzt. Die Vereinzelung der auf dem Separatorband 1 angeordneten Bizellen erfolgt durch Auftrennung des Bandes durch einen Schnitt durch den Separator unmittelbar nach der erfindungsgemäßen Impedanzmessung. Unmittelbar nach der Messung kann eine defekte Bizelle beispielsweise durch Abschneiden eines Ableiters 3 markiert und aussortiert werden. Diese Verfahren können dem Herstellungsprozess der Bizellen ohne zeitliche Einbußen direkt nachgeschaltet werden.

Erfindungsgemäß kann das Impedanzmessverfahren auch zur Kontrolle der Maschinenparameter dienen, denn normalerweise zeigen so vermessene Bizellen eine scharfe Gaußverteilung des Betrags der Impedanzmesswerte, wie sie beispielhaft in Figur 2 dargestellt ist. Die Impedanz ist abhängig von Dicke, Größe und ganz allgemein den chemischen und physikalischen Beschaffenheiten der Zellbestandteile und von Maschinenparametern wie Laminationstemperatur, Druck etc.. Durch die erfindungsgemäße Messung wird die Qualität der Lamination und das Vorhandensein von Kurz- und Feinschlüssen geprüft. Es ist somit eine 100%ige Prüfung der Bizellen auf Fein- und Kurzschlüsse, Qualität der Lamination und Vollständigkeit der Bizellenbestandteile im laufenden Produktionsprozess unmittelbar nach der Lamination möglich. Ohne dieses Prüfverfahren werden defekte Bizellen zu galvanischen Elementen komplettiert und das komplette Element wird dann frühestens während bzw. nach der Formation erkannt und aussortiert. Dies ist dann sehr aufwendig und nachteilig.

In Figur 2 sind die Impedanzmessergebnisse kumulativ aufgetragen. Als abhängige Größe sind die gemessenen Impedanzwerte über der relativen Häufigkeit ihres Auftretens aufgetragen. Die Grenzen für eine Schlechtausprüfung liegen bei dem Beispiel bei einer Impedanz von ca. 43 kΩ als obere und 37 kΩ als untere Grenze. Die dabei verwendeten Bizellen haben Abmessungen von ca. 6 x 3 cm² und eine Dicke von ca. 550 µm. Sie sind aufgebaut aus positive Elektrode / Separator / negative Elektrode / Separator / positive Elektrode. Das Aktivmaterial der negativen Elektrode ist insbesondere ein modifizierter Graphit. Das Aktivmaterial der positiven Elektrode ist beispielsweise ein ternäres Lithiumübergangsmetalloxid. Als Ableitermaterialien sind Kupferfolie für die negative Elektrode und Aluminiumstreckmetall für die positive Elektrode geeignet. Soweit die Zellen noch einen Weichmacher enthalten, wird dieser in einem folgenden Produktionsschritt mittels eines n-Alkans extrahiert.

## Patentansprüche

1. Verfahren zur Herstellung von galvanischen Elementen, die aus einer Vielzahl aufeinander gestapelter Einzelzellen bestehen, die jeweils aus auf einen Separator (1) laminierten Elektrodenfolien bestehen, wobei mindestens eine der Elektroden (2) eine Lithium-interkalierende Elektrode ist, in deren Polymermatrix im Polymer unlösliche elektrochemisch aktive Materialien fein dispergiert sind, **dadurch gekennzeichnet, dass** die Funktionsfähigkeit der Einzelzellen vor dem Einbringen eines organischen Elektrolyten und vor der Bildung eines Zellenstapels durch Messung der Impedanz der Einzelzelle überprüft wird.

2. Verfahren nach Anspruch 1, **dadurch gekennzeichnet, dass** Betrag und/oder Phasenwinkel der Impedanz ausgewertet werden.

3. Verfahren nach Anspruch 1 oder 2, **dadurch gekennzeichnet, dass** die Messung der Impedanz mittels Wechselspannung oder Wechselstrom erfolgt.

4. Verfahren nach einem der Ansprüche 1 bis 3, **dadurch gekennzeichnet, dass** die Impedanzmessung als Vierpolmessung bei einer Frequenz von 100 Hz bis 100 kHz, vorzugsweise von ca. 1 kHz, erfolgt.

5. Verfahren nach einem der Ansprüche 1 bis 4, **dadurch gekennzeichnet, dass** das Laminat Ableiter (3) aufweist und die Impedanzbestimmung mittels Federkontakten (4) erfolgt, die die Ableiter des Laminats kontaktieren.

6. Verfahren nach einem der Ansprüche 1 bis 5, **dadurch gekennzeichnet, dass** die ermittelten Impedanzwerte kumulativ gesammelt, aus den Messwerten eine Verteilungskurve gebildet wird und Einzelzellen, deren Impedanz außerhalb von vorher bestimmten Grenzwerten der Verteilungskurve liegen, aussortiert werden.

7. Verfahren nach einem der Ansprüche 1 bis 6, **dadurch gekennzeichnet, dass** Ausschusszellen markiert werden, insbesondere durch Abschneiden eines Ableiters (3) des Laminats.
